# FASCICULE DE BREVET EUROPEEN

(11) **EP 3 379 145 B1**
(45) Date de publication et mention de la délivrance du brevet: **12.01.2022**
(21) Numéro de dépôt: 18162242.4
(22) Date de dépôt: 16.03.2018
(51) Int. Cl.: F21V 29/77, F21V 29/71, F21S 45/49, F21S 45/43

(54) **DISPOSITIF DE REFROIDISSEMENT D'UNE SOURCE LUMINEUSE**
KÜHLVORRICHTUNG EINER LICHTQUELLE
DEVICE FOR COOLING A LIGHT SOURCE

(30) Priorité: 21.03.2017 FR 1752327
(43) Date de publication de la demande: 26.09.2018
(73) Titulaire: Valeo Vision, 93012 Bobigny Cedex (FR)
(72) Inventeur: REDJEM SAAD, Lotfi, 93012 Bobigny Cedex (FR); DUVAL, Christophe, 93012 Bobigny Cedex (FR); TOURNEMINE, Sylvian, 93012 Bobigny Cedex (FR)
(74) Mandataire: Valeo Visibility

(56) Documents cités:
- WO-A1-2014/007411
- DE-A1-102006 001 711
- US-A1- 2010 132 931
- US-A1- 2013 294 093
- US-A1- 2014 218 932

## Description

### Domaine technique de l'invention

L'invention concerne un dispositif de refroidissement d'une source lumineuse, notamment d'une diode laser. Elle concerne aussi un bloc projecteur de véhicule automobile comprenant un tel dispositif de refroidissement d'une source lumineuse. Elle concerne également un véhicule automobile équipé d'un tel bloc projecteur ou d'un tel dispositif de refroidissement d'une source lumineuse. Enfin, elle concerne un procédé de fabrication d'un tel dispositif de refroidissement d'une source lumineuse.

### État de la technique

Une source lumineuse, particulièrement une diode laser, a besoin d'être refroidie, notamment lorsqu'elle est destinée à éclairer la route devant un véhicule automobile. En effet, un véhicule automobile peut être soumis à des températures extérieures très élevées alors que le conducteur a besoin d'allumer les phares. C'est par exemple le cas au cours des nuits estivales très chaudes. Or, si la température dépasse un certain seuil, la fonction d'éclairage est fortement diminuée, voire totalement supprimée. Les solutions de refroidissement de l'état de la technique s'avèrent souvent insuffisantes. De plus, elles ont tendance à augmenter les surfaces d'échange thermique, ce qui engendre des dispositifs de refroidissement volumineux. Or, le nombre important d'équipements au sein des véhicules automobiles rend difficile l'intégration de dispositifs de refroidissement encombrants. Les documents WO 2014/007411 A1, US 2013/294093 A1 et US 2010/132931 A1 divulguent des dispositifs d'éclairage connus de l'art antérieur.

### Objet de l'invention

Le but de la présente invention est de proposer une solution de refroidissement compacte et efficace d'une source lumineuse, notamment d'une diode laser, particulièrement compatible avec une utilisation au sein d'un véhicule.

Pour cela, l'invention repose sur un dispositif de refroidissement d'une source lumineuse, notamment d'une diode électroluminescente de type LED ou laser, comprenant un premier dissipateur thermique muni d'un noyau doté d'un alésage s'étendant selon un axe d'éclairage et formant un logement pour recevoir une telle source lumineuse, et comprenant des premières ailettes s'étendant depuis le noyau vers l'extérieur, le dispositif de refroidissement comprenant un deuxième dissipateur thermique qui présente des deuxièmes ailettes s'étendant vers l'axe d'éclairage depuis une partie périphérique agencée autour de l'axe d'éclairage, au moins une deuxième ailette du deuxième dissipateur thermique étant au moins partiellement imbriquée entre des premières ailettes du premier dissipateur thermique.

Selon une première variante, le premier dissipateur thermique et le deuxième dissipateur thermique sont deux pièces distinctes, imbriquées l'une dans l'autre.

Selon une seconde variante, le premier dissipateur thermique et le deuxième dissipateur thermique sont d'un seul tenant, c'est-à-dire qu'ils forment une pièce unique.

Selon l'invention, le deuxième dissipateur thermique comprend une plaque latérale sensiblement perpendiculaire à l'axe d'éclairage, notamment une plaque latérale circulaire, dotée d'un trou central sensiblement coaxial à l'axe d'éclairage, des branches s'entendent vers l'extérieur depuis la plaque latérale jusqu'à la partie périphérique, ces branches maintiennent la partie périphérique sensiblement coaxialement à l'axe d'éclairage.

La plaque latérale du deuxième dissipateur thermique présente une face intérieure en contact avec une face annulaire du noyau du premier dissipateur thermique pour permettre une dissipation de chaleur du premier dissipateur thermique vers le deuxième dissipateur thermique.

Le noyau du premier dissipateur thermique peut être sensiblement cylindrique et la partie périphérique du deuxième dissipateur thermique peut être sensiblement cylindrique.

Les extrémités distales des premières ailettes du premier dissipateur thermique peuvent être inscrites dans un cylindre de diamètre inférieur au diamètre dans lequel s'inscrit la paroi intérieure de la partie périphérique du deuxième dissipateur thermique.

Les premières et les deuxièmes ailettes, respectivement, des premier et deuxième dissipateurs thermiques, peuvent être toutes partiellement ou totalement imbriquées.

Chaque deuxième ailette du deuxième dissipateur thermique peut être disposée entre deux premières ailettes du premier dissipateur thermique, de sorte à ce qu'un espace subsiste entre les premières et les deuxièmes ailettes.

La partie périphérique du deuxième dissipateur thermique peut être inscrite dans un cylindre de diamètre compris entre 40 et 60 mm, voire entre 40 et 100 mm.

Le dispositif de refroidissement peut comprendre un ventilateur d'axe sensiblement coaxial à l'axe d'éclairage, disposé en vis-à-vis d'une face extérieure de la plaque latérale du deuxième dissipateur thermique, apte à générer un courant d'air pénétrant au sein des premier et deuxième dissipateurs thermiques pour induire un refroidissement de ces dissipateurs thermiques par convection au niveau de leurs ailettes.

Le noyau du premier dissipateur thermique peut former un composant de maintien d'une source lumineuse et notamment un support permettant la liaison entre une diode laser et une fibre optique.

L'invention porte également sur un bloc projecteur de véhicule automobile comprenant un dispositif de refroidissement tel que décrit précédemment.

L'invention porte encore sur un véhicule automobile comprenant un dispositif de refroidissement tel que décrit précédemment et/ou un bloc projecteur de véhicule automobile tel que décrit précédemment.

### Description sommaire des dessins

D'autres avantages et caractéristiques ressortiront plus clairement de la description qui va suivre d'un mode de réalisation de l'invention donné à titre d'exemple non limitatif et représenté sur les dessins annexés, dans lesquels :
La figure 1 représente une vue en perspective d'un dispositif de refroidissement d'une source lumineuse selon un mode de réalisation de l'invention.
La figure 2 représente une vue éclatée en perspective d'une source lumineuse s'étendant suivant un axe d'éclairage A munie du dispositif de refroidissement selon le mode de réalisation de l'invention.
La figure 3 représente une vue en perspective d'un premier et d'un deuxième dissipateur thermique du dispositif de refroidissement selon le mode de réalisation de l'invention.
La figure 4 représente une vue de face d'un premier et d'un deuxième dissipateur thermique du dispositif de refroidissement selon le mode de réalisation de l'invention.
La figure 5 représente une vue en coupe, selon un plan comprenant l'axe d'éclairage A, d'une source lumineuse munie du dispositif de refroidissement selon le mode de réalisation de l'invention.
La figure 6 représente une vue en perspective d'un diffuseur monté sur un premier et un deuxième dissipateur thermique du dispositif de refroidissement selon le mode de réalisation de l'invention.

### Description de modes de réalisation de l'invention

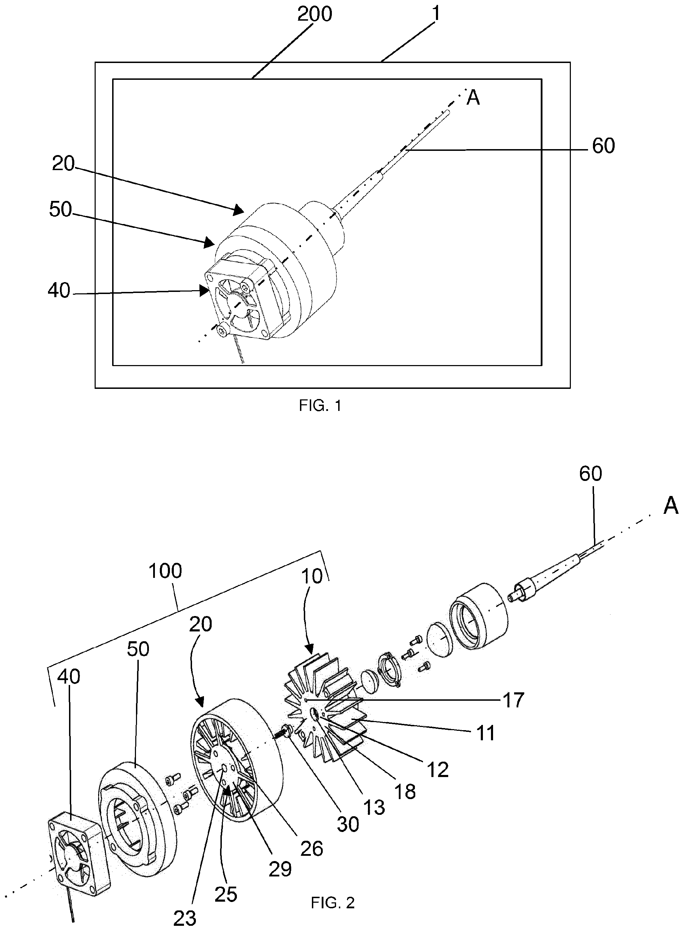

Les figures 1 à 6 illustrent un dispositif de refroidissement 100 d'une source lumineuse, notamment d'une diode laser 30, apte à éclairer l'avant, voire l'arrière, d'un véhicule automobile 1 selon un mode préféré de réalisation de l'invention.

Comme illustré schématiquement sur la figure 1, le véhicule automobile 1 est équipé d'un bloc projecteur 200. Une source lumineuse s'étendant selon un axe d'éclairage A, via de la fibre optique 60, est refroidie par le dispositif de refroidissement 100.

A noter que sur les figures 1, 2, 3 et 5, par commodité, l'axe d'éclairage A est illustré comme étant sensiblement coaxial à la source lumineuse, la fibre optique 60 étant illustrée rectiligne. Il faut bien comprendre que la lumière est créée dans la source lumineuse, puis est transmise dans la fibre optique 60 par une première extrémité reliée à la source lumineuse, avant de ressortir par une deuxième extrémité de la fibre optique 60. Ainsi, la source lumineuse peut être placée de manière quelconque par rapport à la direction d'éclairage, la fibre optique 60 n'étant pas forcément rectiligne et pouvant faire une voire plusieurs courbes.

Selon un mode de réalisation, le bloc projecteur 200 comprend un dispositif de refroidissement 100 tel qu'illustré sur la figure 2. Le dispositif de refroidissement 100 comprend un premier dissipateur thermique 10, un deuxième dissipateur thermique 20, un diffuseur 50, et un ventilateur 40.

Le premier dissipateur thermique 10 concourt au maintien de la diode laser 30. Cette diode laser 30 est de forme sensiblement cylindrique, éventuellement d'axe sensiblement coaxial à l'axe d'éclairage A comme illustré sur les figures, et comprend éventuellement un épaulement. Un noyau 12 du premier dissipateur thermique 10 forme alors un composant de maintien de la diode laser 30. En effet, ce noyau 12 est doté d'un alésage 13 s'étendant suivant l'axe d'éclairage A et formant un logement pour recevoir la diode laser 30. Cet alésage 13 a un diamètre tel que la diode laser 30 s'y insère avec un jeu fonctionnel de sorte à ce qu'un maximum de chaleur émanant de la diode laser 30 soit transféré au noyau 12. En outre, le noyau 12 assure une fonction de support permettant la liaison entre la diode laser 30 et la fibre optique 60.

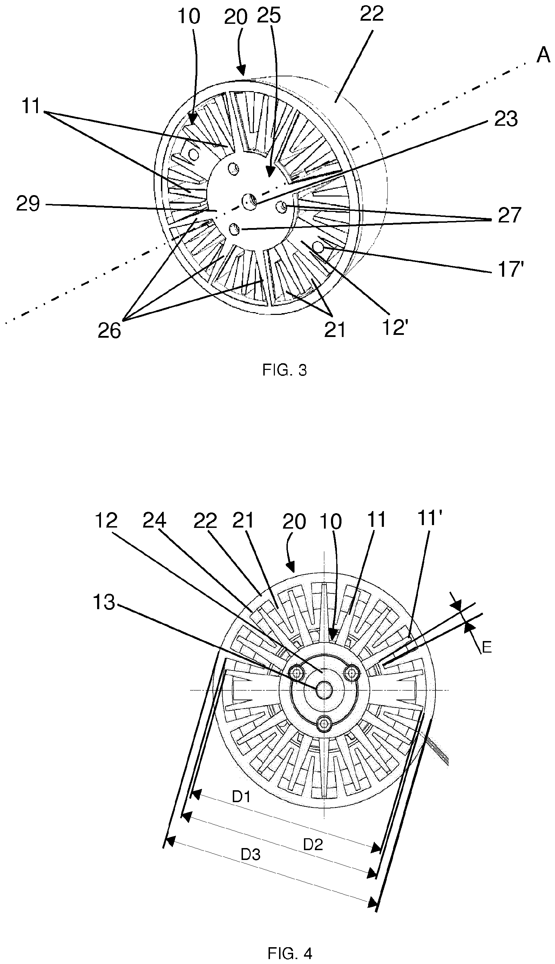

En référence aux figures 2 et 3, le ventilateur 40 est apte à souffler ou aspirer de l'air frais en direction d'une face extérieure 29 d'une plaque latérale 25 du deuxième dissipateur thermique 20. L'agencement est tel que l'air aspiré par le ventilateur 40 traverse les deux dissipateurs thermiques 10, 20, pour favoriser leur refroidissement par convection. Le ventilateur 40 a un axe de rotation sensiblement coaxial à l'axe d'éclairage A. Le ventilateur 40 est apte à aspirer de l'air frais au sein du deuxième dissipateur thermique 20 après que l'air ait traversé un diffuseur 50. Le ventilateur 40 est également apte à souffler, c'est-à-dire refouler de l'air chaud, pour désembuer par exemple.

Comme illustré sur les figures 2, 3 et 4, le premier dissipateur thermique 10 présente des premières ailettes 11 s'étendant, radialement depuis l'axe d'éclairage A sur ce mode de réalisation, depuis le noyau 12 vers l'extérieur. Le deuxième dissipateur thermique 20 présente des deuxièmes ailettes 21 s'étendant vers l'axe d'éclairage A. En effet, une partie périphérique 22 du deuxième dissipateur thermique 20 est agencée autour de l'axe d'éclairage A et comprend les deuxièmes ailettes 21 s'étendant, de même radialement, vers l'intérieur. Dans le mode de réalisation illustré, le noyau 12 du premier dissipateur thermique 10 et la partie périphérique 22 du deuxième dissipateur thermique 20 sont sensiblement cylindriques. La partie périphérique 22 peut également avoir une forme différente, par exemple parallélépipédique, notamment de section carrée, sensiblement dans le prolongement du boîtier de ventilateur 40.

Les premier et deuxième dissipateurs thermiques 10, 20 tels que représentés sur les figures 3 et 4, sont agencés de sorte à ce que toutes les deuxièmes ailettes 21 du deuxième dissipateur thermique 20 soient disposées entre deux premières ailettes 11 du premier dissipateur thermique 10. En variante, les première et deuxième ailettes 11, 21 peuvent être imbriquées selon des architectures différentes. Par exemple, au moins une deuxième ailette 21 est imbriquée entre des premières ailettes 11. Il peut y avoir deux ou plus de deuxièmes ailettes 21 imbriquées entre des premières ailettes 11. La largeur des premières et deuxièmes ailettes 11, 21, mesurée selon l'axe d'éclairage A, peut être égale, et les deux extrémités de ces premières et deuxièmes ailettes 11, 21 peuvent être alignées, c'est-à-dire se trouver sensiblement dans deux plans respectifs perpendiculaires à l'axe d'éclairage A. En variante, les premières et deuxièmes ailettes 11, 21 peuvent être légèrement décalées dans la direction selon l'axe d'éclairage A. Ainsi, toute imbrication dans laquelle au moins une première ailette 11 et une deuxième ailette 21 présentent des surfaces respectives en vis-à-vis et à proximité permet d'obtenir un premier effet de compacité et un second effet de participation combinée au refroidissement. Une imbrication totale, comme dans le mode de réalisation, est particulièrement otpimale.

Avantageusement, le dispositif de refroidissement 100 comprend au moins trois premières et trois deuxièmes ailettes 11, 21. Dans le mode de réalisation illustré, dix-huit premières ailettes 11 et seize deuxièmes ailettes 21 sont implémentées. Naturellement des nombres différents de premières et deuxièmes ailettes 11, 21 peuvent convenir.

Comme évoqué précédemment, le deuxième dissipateur thermique 20 comprend une plaque latérale 25. Cette plaque latérale 25, sensiblement perpendiculaire à l'axe d'éclairage A, est dotée d'un trou central 23 sensiblement coaxial à l'axe d'éclairage A. Des branches (ou bras) 26, au nombre de six sur le mode de réalisation illustré, s'étendent de préférence radialement vers l'extérieur depuis la plaque latérale 25 jusqu'à la partie périphérique 22. Les branches 26 assurent le maintien de la partie périphérique 22 sensiblement coaxialement à l'axe d'éclairage A. Le nombre de branches 26 peut bien évidemment être inférieur à six, étant entendu qu'il faut au minimum une branche 26 et de préférence un nombre paire de branches 26. Dans le mode de réalisation illustré, la plaque latérale 25 est circulaire. Comme évoqué précédemment, la face extérieure 29 de la plaque latérale 25 est en vis-à-vis du ventilateur 40.

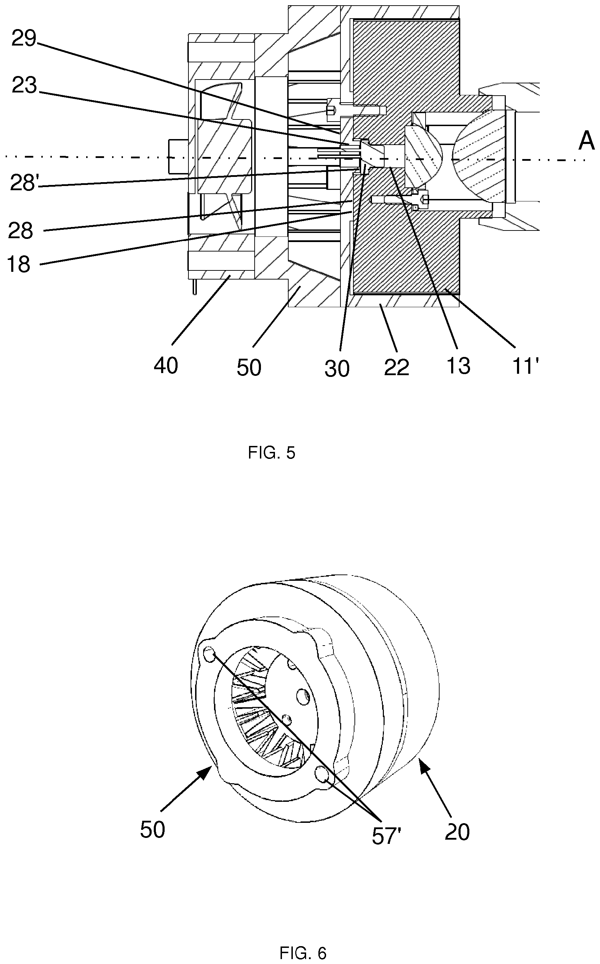

La face intérieure 28 de la plaque latérale 25 du deuxième dissipateur thermique 20 se retrouve en vis-à-vis d'une face annulaire 18 du noyau 12 du premier dissipateur thermique 10 comme le montre la figure 5. Plus précisément, l'agencement du premier dissipateur thermique 10 avec le deuxième dissipateur thermique 20 est tel que la face intérieure 28 de la plaque latérale 25 est en contact avec la face annulaire 18 du noyau 12. Par cet agencement, le premier dissipateur thermique 10, qui reçoit tout ou la majorité de la chaleur provenant de la diode laser 30, transmet une partie de cette chaleur au deuxième dissipateur thermique 20, par conduction thermique au niveau du contact entre la plaque latérale 25 en et la face annulaire 18 du noyau 12. En complément, une partie annulaire 28', provenant notamment d'un épaulement, du côté de la face intérieure 28 de la plaque latérale 25, est en contact avec la diode laser 30, pour recevoir directement une partie de la chaleur générée par la diode laser 30, c'est-à-dire par le bas de la source lumineuse.

En résumé, le dispositif de refroidissement 100 permet une conduction de chaleur depuis la diode laser 30 vers le premier dissipateur thermique 10 et vers le deuxième dissipateur thermique 20. En effet, la diode laser 30 est en contact avec le premier dissipateur thermique 10 au niveau de l'alésage 13 du noyau 12. De plus, la face intérieure 28 de la plaque latérale 25 étant en contact avec la face annulaire 18 du noyau 12, un transfert de chaleur par conduction du noyau 12 vers la plaque latérale 25 se produit. Ainsi, un transfert de chaleur par conduction a également lieu depuis le premier dissipateur thermique 10 vers le deuxième dissipateur thermique 20. La chaleur émanant de la diode laser 30 étant transmise aux premier et deuxième dissipateurs thermiques 10, 20, il est alors préférable qu'ils soient aptes à se refroidir rapidement afin d'assurer au mieux leur fonction de dissipation de chaleur.

Ainsi, au sein de chaque dissipateur thermique 10, 20, la chaleur est notamment répartie dans les différentes ailettes pour favoriser la dissipation de chaleur et le refroidissement de l'ensemble. Le deuxième dissipateur thermique 20 peut dissiper par conduction une partie de la chaleur de la plaque latérale 25 par les branches 26 puis vers la partie périphérique 22, et enfin vers les ailettes 21.

En outre, le ventilateur 40 génère un flux d'air s'écoulant entre les premières et les deuxièmes ailettes 11, 21 ce qui a pour effet d'améliorer le refroidissement des premières ailettes 11, par convection forcée. Les deuxièmes ailettes 21 et la partie périphérique 22 jouent alors un rôle de guidage de l'air optimisant ainsi le phénomène de convection et concourant au refroidissement du premier dissipateur thermique 10 et du deuxième dissipateur thermique 20.

D'autre part, comme illustré sur la figure 3, le trou central 23 de la plaque latérale 25 peut être directement aligné avec l'arrière de la diode laser 30.

Avantageusement, comme illustré sur la figure 4, les extrémités distales 11' des premières ailettes 11 du premier dissipateur thermique 10 sont inscrites dans un cylindre de diamètre D1 inférieur au diamètre D2 du cylindre dans lequel la paroi intérieure 24 de la partie périphérique 22 du deuxième dissipateur thermique 20 est inscrite. Ainsi, les extrémités distales 11' des premières ailettes 11 ne viennent pas en contact avec la partie périphérique 22 du deuxième dissipateur thermique 20, mais à à proximité de cette partie périphérique 22. Par ce biais, les premières ailettes 11 occupent un volume maximal dans l'espace disponible délimité par la partie périphérique 22.

De plus, chaque deuxième ailette 21 du deuxième dissipateur thermique 20 est agencée entre deux premières ailettes 11 du premier dissipateur thermique 10, de sorte à ce qu'un espace E minimal subsiste entre les premières et les deuxièmes ailettes 11, 21. Cet espace E peut être compris par exemple entre 1 mm et 4 mm, de préférence entre 2 et 3 mm. Un tel agencement des premières et des deuxièmes ailettes 11, 21 et de tels écarts entre les premières ailettes 11 et les deuxièmes ailettes 21 maximisent la convection forcée. Le refroidissement est d'autant plus efficace que la surface d'échange entre l'air et les premières et deuxièmes ailettes 11, 21 est importante. En remarque, l'agencement des premières et deuxièmes ailettes 11, 21 peut être différent, comme explicité précédemment, tout en formant une imbrication de ces ailettes permettant de présenter des surfaces respectives à proximité les unes des autres pour favoriser la dissipation et/ou minimiser l'encombrement.

De préférence, (D2 - D1) est inférieure à la valeur de l'espace E, voire (D2 - D1) / 2 est inférieure à la valeur de l'espace E. Ceci dans le but de forcer l'air à passer là où il y a le maximum de place, c'est à dire entre les premières et deuxièmes ailettes 11, 21, et non entre les extrémités distales 11' des premières ailettes 11 et la paroi intérieure 24 de la partie périphérique 22 du deuxième dissipateur thermique 20.

Toujours en référence à la figure 4, la partie périphérique 22 du deuxième dissipateur thermique 20 est avantageusement inscrite dans un cylindre de diamètre D3 compris entre 40 et 100 mm, de préférence entre 40 et 60 mm. La longueur suivant l'axe d'éclairage A du premier dissipateur thermique 10 imbriqué dans le deuxième dissipateur thermique 20, est comprise entre 30 et 50 mm, de préférence de l'ordre de 35 mm.

Les figures 5 et 6 illustrent notamment la compacité du dispositif de refroidissement 100 comprenant le ventilateur 40, le diffuseur 50 et les premier et deuxième dissipateurs thermiques 10, 20. Sur la figure 6, seuls le diffuseur 50 et les premier et deuxième dissipateurs thermiques 10, 20 sont représentés. Le faible encombrement du dispositif de refroidissement 100 est dû au fait que le premier dissipateur thermique 10 est imbriqué au sein du deuxième dissipateur thermique 20. De plus, la surface d'échange thermique reste très importante, notamment du fait des premières ailettes 11 et des deuxièmes ailettes 21, ce qui assure un refroidissement optimal de la diode laser 30.

A noter que le premier dissipateur thermique 10 peut être maintenu sensiblement centré au sein du deuxième dissipateur thermique 20 par des premiers moyens de fixation tels que des vis ou des boulons. Ces premiers moyens de fixation peuvent utiliser des premiers alésages 17 s'étendant sensiblement parallèlement à l'axe d'éclairage A dans le noyau 12 du premier dissipateur thermique 10. Ces premiers moyens de fixation peuvent également utiliser des premiers trous 27 parallèles à l'axe d'éclairage A dans la plaque latérale 25 du deuxième dissipateur thermique 20. Les premiers alésages 17 ou les premiers trous 27 peuvent être taraudés.

Le diffuseur 50 peut être fixé par des deuxièmes moyens de fixation, tels que des vis ou des boulons, sur le premier dissipateur thermique 10. Ces deuxièmes moyens de fixation peuvent utiliser des deuxièmes alésages 17' s'étendant sensiblement parallèlement à l'axe d'éclairage A dans une base élargie 12' entre deux premières ailettes 11 du premier dissipateur thermique 10. Ces deuxièmes moyens de fixation peuvent également utiliser des deuxièmes trous 57' s'étendant sensiblement parallèlement à l'axe d'éclairage A dans une zone périphérique du diffuseur 50. Les deuxièmes alésages 17' ou les deuxièmes trous 57' peuvent être taraudés.

En variante non illustrée, les premières ailettes 11 du premier dissipateur thermique 10 et les deuxièmes ailettes 21 du deuxième dissipateur thermique 20 font sensiblement la même longueur. Il en résulte que le diamètre D1 est égal ou sensiblement égal au diamètre D2. Ainsi, les extrémités distales 11' des premières ailettes 11 viennent presque en contact avec la paroi intérieure 24 de la partie périphérique 22.

En remarque, la solution atteint donc l'objet recherché d'offrir un refroidissement optimal d'une diode laser 30 tout en ayant un encombrement réduit. Elle présente l'avantage d'être peu onéreuse, les matériaux et les techniques d'obtention des premier et deuxième dissipateurs thermiques 10, 20 étant largement utilisés. En effet, ils peuvent être produits avec des matériaux courants tels qu'un alliage d'aluminium, tout métal, une matière plastique, par exemple une matière plastique conductrice, ou encore une association de ces matériaux. Pour l'obtention du premier et du deuxième dissipateur thermique 10, 20, l'extrusion et/ou le moulage, éventuellement suivi d'opération(s) d'usinage forment des étapes de fabrication particulièrement intéressantes.

L'invention est particulièrement bien adaptée au refroidissement d'une source lumineuse, telle qu'une diode électroluminescente de type LED ou laser, destinée à l'éclairage d'un véhicule automobile. Elle porte aussi sur un bloc projecteur d'un véhicule automobile en tant que tel intégrant un tel dispositif de refroidissement d'une source lumineuse. Elle porte également sur un véhicule automobile en tant que tel intégrant un tel bloc projecteur ou un tel dispositif de refroidissement d'une source lumineuse.

## Revendications

1. Dispositif de refroidissement (100) d'une source lumineuse, notamment d'une diode électroluminescente de type LED ou laser (30), comprenant un premier dissipateur thermique (10) muni d'un noyau (12) doté d'un alésage (13) s'étendant selon un axe d'éclairage (A) et formant un logement pour recevoir une telle source lumineuse, et comprenant des premières ailettes (11) s'étendant depuis le noyau (12) vers l'extérieur, et comprenant un deuxième dissipateur thermique (20) qui présente des deuxièmes ailettes (21) s'étendant vers l'axe d'éclairage (A) depuis une partie périphérique (22) agencée autour de l'axe d'éclairage (A), au moins une deuxième ailette (21) du deuxième dissipateur thermique (20) étant au moins partiellement imbriquée entre des premières ailettes (11) du premier dissipateur thermique (10), **caractérisé en ce que** le deuxième dissipateur thermique (20) comprend une plaque latérale (25) sensiblement perpendiculaire à l'axe d'éclairage (A), notamment une plaque latérale (25) circulaire, dotée d'un trou central (23) sensiblement coaxial à l'axe d'éclairage (A), des branches (26) s'étendant vers l'extérieur depuis la plaque latérale (25) jusqu'à la partie périphérique (22), ces branches (26) maintenant la partie périphérique (22) sensiblement coaxialement à l'axe d'éclairage (A), la plaque latérale (25) du deuxième dissipateur thermique (20) présente une face intérieure (28) en contact avec une face annulaire (18) du noyau (12) du premier dissipateur thermique (10) pour permettre une dissipation de chaleur du premier dissipateur thermique (10) vers le deuxième dissipateur thermique (20).

2. Dispositif de refroidissement (100) selon la revendication précédente, **caractérisé en ce que** le noyau (12) du premier dissipateur thermique (10) est sensiblement cylindrique et ce que la partie périphérique (22) du deuxième dissipateur thermique (20) est sensiblement cylindrique.

3. Dispositif de refroidissement (100) selon l'une des revendications précédentes, **caractérisé en ce que** les extrémités distales (11') des premières ailettes (11) du premier dissipateur thermique (10) sont inscrites dans un cylindre de diamètre (D1) inférieur au diamètre (D2) dans lequel s'inscrit la paroi intérieure (24) de la partie périphérique (22) du deuxième dissipateur thermique (20).

4. Dispositif de refroidissement (100) selon l'une des revendications précédentes, **caractérisé en ce que** les premières et les deuxièmes ailettes (11, 21), respectivement, des premier et deuxième dissipateurs thermiques (10, 20), sont toutes partiellement ou totalement imbriquées.

5. Dispositif de refroidissement (100) selon l'une des revendications précédentes, **caractérisé en ce que** chaque deuxième ailette (21) du deuxième dissipateur thermique (20) est disposée entre deux premières ailettes (11) du premier dissipateur thermique (10), de sorte à ce qu'un espace (E) subsiste entre les premières et les deuxièmes ailettes (11, 21).

6. Dispositif de refroidissement (100) selon l'une des revendications précédentes, **caractérisé en ce que** la partie périphérique (22) du deuxième dissipateur thermique (20) est inscrite dans un cylindre de diamètre (D3) compris entre 40 et 60 mm, voire entre 40 et 100 mm.

7. Dispositif de refroidissement (100) selon l'une des revendications précédentes, **caractérisé en ce qu'**il comprend un ventilateur (40) d'axe sensiblement coaxial à l'axe d'éclairage (A), disposé en vis-à-vis d'une face extérieure (29) de la plaque latérale (25) du deuxième dissipateur thermique (20), apte à générer un courant d'air pénétrant au sein des premier et deuxième dissipateurs thermiques (10, 20) pour induire un refroidissement de ces dissipateurs thermiques par convection au niveau de leurs ailettes (11, 21).

8. Dispositif de refroidissement (100) selon l'une des revendications précédentes, **caractérisé en ce que** le noyau (12) du premier dissipateur thermique (10) forme un composant de maintien d'une source lumineuse et notamment un support permettant la liaison entre une diode laser (30) et une fibre optique (60).

9. Bloc projecteur (200) de véhicule automobile (1), comprenant un dispositif de refroidissement (100) selon l'une des revendications précédentes.

10. Véhicule automobile (1) **caractérisé en ce qu'**il comprend un dispositif de refroidissement (100) selon l'une des revendications 1 à 8, et/ou un bloc projecteur (200) de véhicule automobile (1) selon la revendication précédente.

## Patentansprüche

1. Kühlvorrichtung (100) einer Lichtquelle, insbesondere einer Elektrolumineszenzdiode des Typs LED oder Laser (30), die einen ersten Wärmeableiter (10) enthält, der mit einem Kern (12) ausgestattet ist, der mit einer Bohrung (13) versehen ist, die sich gemäß einer Beleuchtungsachse (A) erstreckt und eine Aufnahme bildet, um eine solche Lichtquelle aufzunehmen, und erste Lamellen (11) enthält, die sich vom Kern (12) nach außen erstrecken, und einen zweiten Wärmeableiter (20) enthält, der zweite Lamellen (21) aufweist, die sich ausgehend von einem Umfangsbereich (22) zur Beleuchtungsachse (A) erstrecken, der um die Beleuchtungsachse (A) herum angeordnet ist, wobei mindestens eine zweite Lamelle (21) des zweiten Wärmeableiters (20) zumindest teilweise zwischen ersten Lamellen (11) des ersten Wärmeableiters (10) verschachtelt ist, **dadurch gekennzeichnet, dass** der zweite Wärmeableiter (20) eine seitliche Platte (25) im Wesentlichen lotrecht zur Beleuchtungsachse (A) enthält, insbesondere eine kreisförmige seitliche Platte (25), die mit einem zentralen Loch (23) im Wesentlichen koaxial zur Beleuchtungsachse (A) versehen ist, wobei Zweige (26) sich ausgehend von der seitlichen Platte (25) bis zum Umfangsbereich (22) nach außen erstrecken, wobei diese Zweige (26) den Umfangsbereich (22) im Wesentlichen koaxial zur Beleuchtungsachse (A) halten, die seitliche Platte (25) des zweiten Wärmeableiters (20) eine Innenseite (28) in Kontakt mit einer ringförmigen Seite (18) des Kerns (12) des ersten Wärmeableiters (10) aufweist, um eine Wärmeableitung vom ersten Wärmeableiter (10) zum zweiten Wärmeableiter (20) zu erlauben.

2. Kühlvorrichtung (100) nach dem vorhergehenden Anspruch, **dadurch gekennzeichnet, dass** der Kern (12) des ersten Wärmeableiters (10) im Wesentlichen zylindrisch ist, und dass der Umfangsbereich (22) des zweiten Wärmeableiters (20) im Wesentlichen zylindrisch ist.

3. Kühlvorrichtung (100) nach einem der vorhergehenden Ansprüche, **dadurch gekennzeichnet, dass** die distalen Enden (11') der ersten Lamellen (11) des ersten Wärmeableiters (10) in einem Zylinder mit einem Durchmesser (D1) enthalten sind, der kleiner ist als der Durchmesser (D2), in dem die Innenwand (24) des Umfangsbereichs (22) des zweiten Wärmeableiters (20) enthalten ist.

4. Kühlvorrichtung (100) nach einem der vorhergehenden Ansprüche, **dadurch gekennzeichnet, dass** die ersten bzw. zweiten Lamellen (11, 21) der ersten und zweiten Wärmeableiter (10, 20) alle teilweise oder ganz verschachtelt sind.

5. Kühlvorrichtung (100) nach einem der vorhergehenden Ansprüche, **dadurch gekennzeichnet, dass** jede zweite Lamelle (21) des zweiten Wärmeableiters (20) zwischen zwei ersten Lamellen (11) des ersten Wärmeableiters (10) so angeordnet ist, dass noch ein Raum (E) zwischen den ersten und zweiten Lamellen (11, 21) besteht.

6. Kühlvorrichtung (100) nach einem der vorhergehenden Ansprüche, **dadurch gekennzeichnet, dass** der Umfangsbereich (22) des zweiten Wärmeableiters (20) in einem Zylinder eines Durchmessers (D3) zwischen 40 und 60 mm, sogar zwischen 40 und 100 mm enthalten ist.

7. Kühlvorrichtung (100) nach einem der vorhergehenden Ansprüche, **dadurch gekennzeichnet, dass** sie ein Gebläse (40) mit einer Achse im Wesentlichen koaxial zur Beleuchtungsachse (A) enthält, das gegenüber einer Außenseite (29) der seitlichen Platte (25) des zweiten Wärmeableiters (20) angeordnet ist, das einen Luftstrom erzeugen kann, der in den ersten und den zweiten Wärmeableiter (10, 20) eindringt, um eine Kühlung dieser Wärmeableiter durch Konvektion im Bereich ihrer Lamellen (11, 21) zu induzieren.

8. Kühlvorrichtung (100) nach einem der vorhergehenden Ansprüche, **dadurch gekennzeichnet, dass** der Kern (12) des ersten Wärmeableiters (10) ein Haltebauteil einer Lichtquelle und insbesondere einen Träger bildet, der die Verbindung zwischen einer Laserdiode (30) und einer Lichtleitfaser (60) erlaubt.

9. Scheinwerfereinheit (200) eines Kraftfahrzeugs (1), die eine Kühlvorrichtung (100) nach einem der vorhergehenden Ansprüche enthält.

10. Kraftfahrzeug (1), **dadurch gekennzeichnet, dass** es eine Kühlvorrichtung (100) nach einem der Ansprüche 1 bis 8, und/oder eine Scheinwerfereinheit (200) eines Kraftfahrzeugs (1) nach dem vorhergehenden Anspruch enthält.

## Claims

1. Device (100) for cooling a light source, in particular a light-emitting LED or laser diode (13), comprising a first heatsink (10) equipped with a core (12) provided with a bore (13) extending along a lighting axis (A) and forming a housing for receiving such a light source, and comprising first fins (11) extending from the core (12) outward, and comprising a second heatsink (20) that has second fins (21) extending toward the lighting axis (A) from a peripheral portion (22) arranged around the lighting axis (A), at least one second fin (21) of the second heatsink (20) being at least partially interleaved between first fins (11) of the first heatsink (10), **characterized in that** the second heatsink (20) comprises a lateral plate (25) substantially perpendicular to the lighting axis (A), in particular a circular lateral plate (25) provided with a central hole (23) that is substantially coaxial with the lighting axis (A), arms (26) extending outward from the lateral plate (25) to the peripheral portion (22), these arms (26) holding the peripheral portion (22) substantially coaxially with the lighting axis (A) the lateral plate (25) of the second heatsink (20) has an interior face (28) in contact with an annular face (18) of the core (12) of the first heatsink (10) in order to allow heat to be dissipated from the first heatsink (10) to the second heatsink (20).

2. Cooling device (100) according to one of the preceding claims, **characterized in that** the core (12) of the first heatsink (10) is substantially cylindrical and **in that** the peripheral portion (22) of the second heatsink (20) is substantially cylindrical.

3. Cooling device (100) according to one of the preceding claims, **characterized in that** the distal ends (11') of the first fins (11) of the first heatsink (10) are inscribed in a circle of diameter (D1) smaller than the diameter (D2) in which the interior wall (24) of the peripheral portion (22) of the second heatsink (20) is inscribed.

4. Cooling device (100) according to one of the preceding claims, **characterized in that** the first and second fins (11, 21), respectively, of the first and second heatsinks (10, 20), are all partially or completely interleaved.

5. Cooling device (100) according to one of the preceding claims, **characterized in that** each second fin (21) of the second heatsink (20) is placed between two first fins (11) of the first heatsink (10), so that a space (P) remains between the first and second fins (11, 21).

6. Cooling device (100) according to one of the preceding claims, **characterized in that** the peripheral portion (22) of the second heatsink (20) is inscribed in a cylinder of diameter (D3) comprised between 40 and 60 mm, or even between 40 and 100 mm.

7. Cooling device (100) according to one of the preceding claims, **characterized in that** it comprises a fan (40) of axis substantially coaxial with the lighting axis (A), placed facing an exterior face (29) of the lateral plate (25) of the second heatsink (20), able to generate an air current that penetrates into the first and second heatsinks (10, 20) in order to induce cooling of these heatsinks by convection level with their fins (11, 21).

8. Cooling device (100) according to one of the preceding claims, **characterized in that** the core (12) of the first heatsink (10) forms a component for holding a light source and in particular a holder allowing the connection between a laser diode (30) and an optical fiber (60).

9. Headlamp unit (200) for a motor vehicle (1), said unit comprising a cooling device (100) according to one of the preceding claims.

10. Motor vehicle (1) **characterized in that** it comprises a cooling device (100) according to one of Claims 1 to 10, and/or a headlamp unit (200) for a motor vehicle (1) according to the preceding claim.
